# EUROPEAN PATENT APPLICATION

(11) **EP 2 658 355 A2**
(43) Date of publication of application: **30.10.2013**
(21) Application number: 13165533.4
(22) Date of filing: 26.04.2013
(51) Int. Cl.: H05K 1/16

(54) **Circuit board, electric device, and method of manufacturing circuit board**

(30) Priority: 27.04.2012 JP 2012103104
(71) Applicant: Koito Manufacturing Co., Ltd., Tokyo 108-8711 (JP)
(72) Inventor: Teraoka, Shinji, Shizuoka (JP); Tsuchiya, Toshiyuki, Shizuoka (JP); Shimizu, Nobuyuki, Shizuoka (JP)
(74) Representative: HOFFMANN EITLE

(57) **Abstract**

A circuit board includes an insulative substrate having a first surface on which an electronic component is mounted, a second surface opposite to the first surface, and a through-hole open in the first surface and the second surface, a first conductive layer formed on the first surface so as to reach the through-hole, to which the electronic component is electrically connected, a second conductive layer formed on the second surface so as to reach the through-hole and electrically connected to the first conductive layer through the through-hole, a third conductive layer formed over the second surface so as to reach the through-hole, covering at least part of the second conductive layer, and filling at least part of the through-hole, a first protective glass layer covering the second conductive layer and the third conductive layer, and an adhesive layer formed on the first protective glass layer.

## Description

### BACKGROUND

### TECHNICAL FIELD

The present disclosure relates to a circuit board, electric device having the circuit board, and a method of manufacturing the circuit board.

### RELATED ART

Among vehicular lamps such as vehicle headlights are ones which are provided with an electric device covered with a metal case. An example of such electric devices is a lighting device of a discharge lamp which is used as a light source of a vehicular lamp.

Such electric devices are provided with a circuit board which functions as a lighting circuit, and the circuit board is fixed to the inner surface of a metal case by bonding, for example.

Among such circuit boards are what is called double-sided circuit boards in which electrical continuity between conductive layers formed on the two respective surfaces is established via a through-hole (refer to Patent document 1, for example). Double-sided circuit boards can be reduced in thickness because conductive layers are formed on the two respective surfaces, that is, both surfaces can be used as a circuit pattern forming surface.

Although double-sided circuit boards can be reduced in thickness, since electrical continuity between conductive layers formed on the two respective surfaces is established via a through-hole, it is necessary to secure good electrical continuity in the through-hole.

Furthermore, since as mentioned above a double-sided circuit board is bonded to the inner surface of a metal case on the side of one surface on which a conductive layer is formed, it is necessary to secure high insulation from the metal case.

[Patent document 1] JP-A-2000-114683

However, in the circuit board disclosed in Patent document 1, electrical continuity between conductive layers formed on the two respective surfaces is established by only a single-layer through-hole conductor formed in a through-hole, and hence there may occur a case that sufficient electrical continuity is not secured between the conductive layers. In particular, since the opening edges of the through-hole are sharp-angled, the conductive layers tend to be thin above the opening edges, resulting in reduction in current capacity.

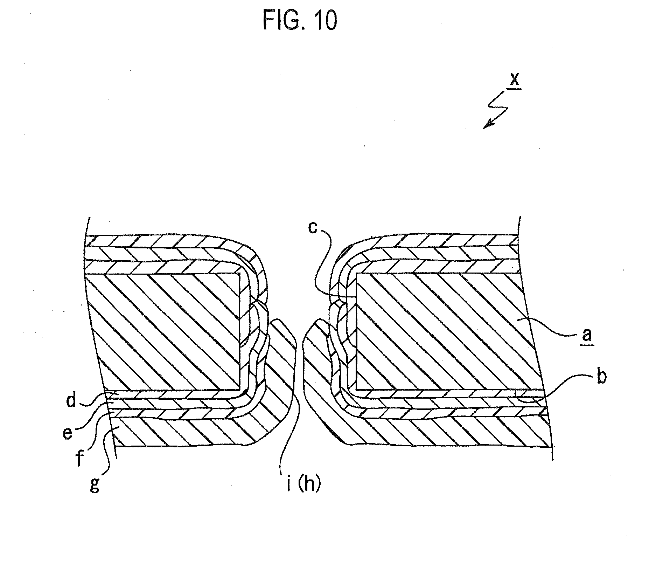

Furthermore, as described below with reference to Fig. 10, related-art circuit boards have a problem that high insulation may not be secured.

Among related-art circuit boards are ones which are like a circuit board x shown in Fig. 10. In the circuit board x, conductive layers d and e are laid on one surface b of a substrate a and part of the inner surface of a through-hole c and are covered with a glass layer f. An insulating layer g is formed on the glass layer f so as to go into the through-hole c to its halfway position.

However, that portion of the insulating layer g which is filled in the through-hole c is thicker than the other portion formed on the one surface b of the substrate a. Therefore, if the circuit board x is subjected to thermal stress repeatedly because of repetitive temperature variations during its manufacture and use in a product, a crack may develop in that portion of the insulating layer g which is filled in the through-hole c and a recess h or a hole i may be formed there. Fig. 10 shows a case that such a hole i is formed through the insulating layer g.

Once the recess h or hole i is formed in or through the insulating layer g, high insulation from a metal case to which the circuit board x is bonded cannot be secured.

### SUMMARY

Exemplary embodiments of the invention provide a circuit board, an electric device and a method of manufacturing the circuit board, in which good electrical continuity can be secured between the conductive layers and high insulation of the circuit board from a metal case can be attained.

A circuit board according to an exemplary embodiment of the invention comprises:
an insulative substrate having a first surface on which an electronic component is mounted, a second surface which is opposite to the first surface, and a through-hole which is open in the first surface and the second surface;
a first conductive layer which is formed on the first surface so as to reach the through-hole and to which the electronic component is electrically connected;
a second conductive layer which is formed on the second surface so as to reach the through-hole and which is electrically connected to the first conductive layer through the through-hole;
a resistance layer which is formed on the second surface and electrically connected to the second conductive layer;
a third conductive layer which is formed over the second surface so as to reach the through-hole, covers at least part of the second conductive layer, and fills at least part of the through-hole;
a first protective glass layer which covers the second conductive layer, the third conductive layer, and the resistance layer; and
an adhesive layer which is formed on the first protective glass layer.

Since the second conductive layer and the third conductive layer are laid in this order on the opening edge of the through-hole, the total thickness of these conductive layers is so large as to secure a sufficient current capacity, whereby good electrical continuity can be secured between the first conductive layer and the second conductive layer.

Since at least part of the through-hole is filled with the third conductive layer, the bonding layer has a flat surface, that is, has no large thickness variation, whereby high insulation of the circuit board from a metal case can be attained.

A method of manufacturing a circuit board according to an exemplary embodiment of the invention, comprises:
forming a through-hole through an insulative substrate having a first surface on which an electronic component is to be mounted and a second surface which is opposite to the first surface in such a manner that the through-hole is open in the first surface and the second surface;
forming a first conductive layer on the first surface so as to reach the through-hole, the first conductive layer being to be electrically connected to the electronic component;
forming a second conductive layer on the second surface so as to reach the through-hole and to be electrically connected to the first conductive layer through the through-hole;
forming a third conductive layer over the second surface so as to reach the through-hole, to cover at least part of the second conductive layer, and to fill at least part of the through-hole;
forming a protective glass layer over the second surface so that it covers the second conductive layer and the third conductive layer; and
forming an adhesive layer on the protective glass layer.

Since the second conductive layer and the third conductive layer are laid in this order on the opening edge of the through-hole, the total thickness of these conductive layers is so large as to secure a sufficient current capacity, whereby good electrical continuity can be secured between the first conductive layer and the second conductive layer.

Since at least part of the through-hole is filled with the third conductive layer, the bonding layer has a flat surface, that is, has no large thickness variation, whereby high insulation of the circuit board from a metal case can be attained.

The circuit board may comprise:
an insulating layer formed between the first protective glass layer and the adhesive layer.

This measure can further increase the insulation of the circuit board from the metal case.

The circuit board may comprise:
a fourth conductive layer which is formed over the first surface so as to reach the through-hole and covers at least part of the first conductive layer; and
a second protective glass layer which is formed over the first surface so as to reach the through-hole and covers at least part of the first conductive layer and at least part of the third conductive layer.

Since the first conductive layer and the fourth conductive layer are laid in this order on the opening edge of the through-hole, the total thickness of these conductive layers is so large as to secure a sufficient current capacity.

An electric device according to an exemplary embodiment of the invention comprises:
a metal case;
the above circuit board attached to the metal case,
wherein the adhesive layer is formed between the first protective glass layer and a surface of the metal case, and
wherein the electric device is used as a lighting device for lighting a light source provided in a vehicular lamp, and the circuit board is provided in a lamp chamber of the vehicular lamp.

In this case, it is not necessary to provide a waterproof portion dedicated to the circuit board. Thus, the circuit board can be simplified in structure and reduced in manufacturing cost.

### BRIEF DESCRIPTION OF THE DRAWINGS

Fig. 1 is a sectional view showing schematically a vehicular lamp using a circuit board according to an exemplary embodiment of the invention.
Fig. 2 is an enlarged sectional view showing a portion of the circuit board.
Fig. 3 is an enlarged sectional view showing a conductive layer 4 formed on the substrate.
Fig. 4 is an enlarged sectional view showing a conductive layer 5 formed on the substrate and electrically connected to the conductive layer 4.
Fig. 5 is an enlarged sectional view showing a conductive layer 9 formed on the substrate.
Fig. 6 is an enlarged sectional view showing a conductive layer 10 formed on the substrate.
Fig. 7 is an enlarged sectional view showing a protective glass layer 11 formed on the substrate.
Fig. 8 is an enlarged sectional view showing a protective glass layer 12 formed on the substrate.
Fig. 9 is an enlarged sectional view showing an insulating layer 13 laid on the protective glass layer 12.
Fig. 10 is an enlarged sectional view showing problems in the related-art circuit board.

### DETAILED DESCRIPTION

Exemplary embodiments of the present invention will be described below with reference to the accompanying drawings.

In the following description, the front, rear, upper, lower, left, and right directions are defined in such a manner that the front direction is defined as the direction to which the light source of a vehicular lamp which is provided with a circuit board is directed, that is, the direction to which light is emitted from the light source.

However, the front, rear, upper, lower, left, and right directions to be used below are just for convenience of description, and should not be construed as limitations in practicing the invention.

A circuit board 1 is provided as part of an electric device which is disposed in a vehicular lamp 50 such as a vehicle headlight.

The vehicular lamp 50 is attached to the vehicle body at each of the front-left and front-right positions.

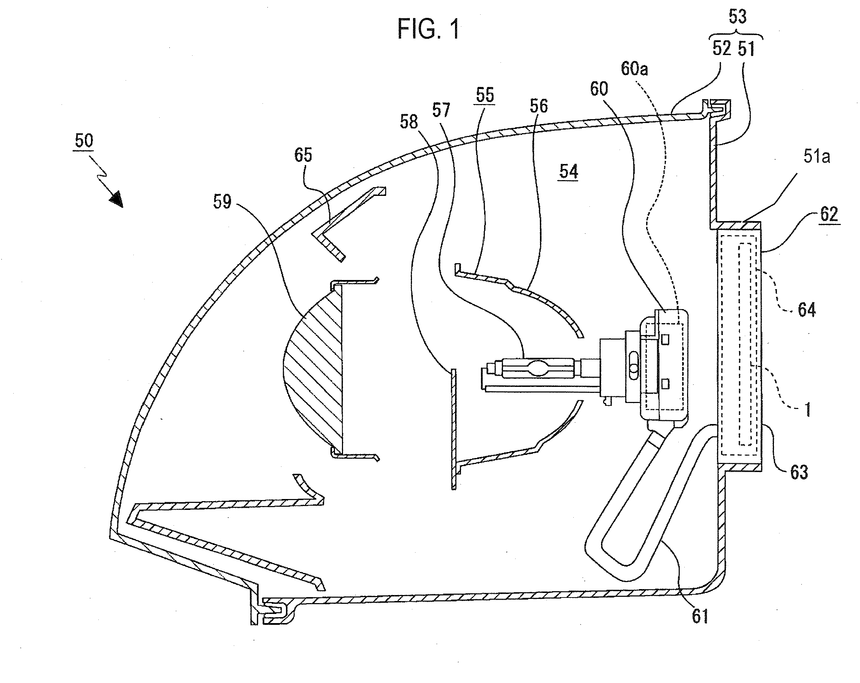

As shown in Fig. 1, the vehicular lamp 50 is equipped with a lamp body 51 having a recess which is open on the front side and a cover 52 which closes the front opening of the lamp body 51

The lamp body 51 and the cover 52 constitute a lamp outer structure 53. The internal space of the lamp outer structure 53 is a lamp chamber 54.

The rear end portion of the lamp body 51 is formed with a generally cylindrical attachment portion 51a.

A lamp unit 55 is provided in the lamp chamber 54. The lamp unit 55 has a reflector 56, a discharge lamp 57 which is held by the reflector 56, a shade 58 which is attached to the reflector 56, and a projection lens 59 which is disposed in front of the discharge lamp 57.

A socket 60 is attached to the rear end portion of the discharge lamp 57, and a starter 60a is provided inside the socket 60.

A cable 61 leads from the socket 60, and the end, opposite to the socket 60, of the cable 61 is connected to a lighting device 62. The lighting device 62 is fitted in the attachment portion 51a of the lamp body 51.

The lighting device 62 is configured in such a manner that an electric device 64 is provided inside a metal case 63. The electric device 64 has the circuit board 1.

Since as described above the lighting device 62 is attached to the attachment portion 51 of the lamp body 51, the circuit board 1 of the electric device 64 is provided inside the lamp chamber 54.

A back cover (not shown) which closes the lighting device 62 may be attached to the attachment portion 51a of the lamp body 51 from behind. The back cover may be integral with the metal case 63 of the lighting device 62.

An extension 65 for interrupting part of the lamp unit 55 is provided in the lamp chamber 54.

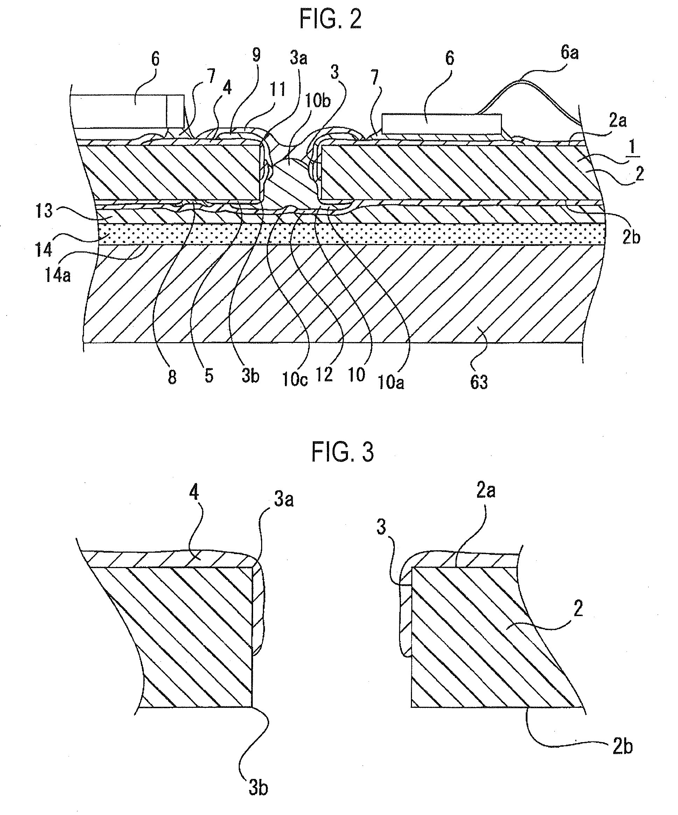

As shown in Fig. 2, the circuit board 1 is configured in such a manner that prescribed components are mounted and prescribed layers are formed on a substrate 2.

The substrate 2 is insulative and is made of ceramic, for example. The front surface and the rear surface of the substrate 2 are a first surface 2a and a second surface 2b, respectively.

A through-hole 3 is formed through the substrate 2 so as to be open in the first surface 2a and the second surface 2b.

A conductive layer 4 (first conductive layer) is formed on the first surface 2a so as to reach the through-hole 3, and a conductive layer 5 (second conductive layer) is formed on the second surface 2b so as to reach the through-hole 3. The portion, formed in the through-hole 3, of the conductive layer 5 is laid on the portion, formed in the through-hole 3, of the conductive layer 4 to establish electrical continuity between them.

Electronic components 6 are mounted on the first surface 2a of the substrate 2 and electrically connected to the conductive layer 4. The electrical components 6 are electrically connected to the conductive layer 4 by joining portions 7 such as solder or joining layers. Part of the electrical components 6 are connected, by wires 6a, to conductive portions (not shown) formed on the first surface 2a.

A resistance layer 8 is formed on the second surface 2b of the substrate 2 so as to be electrically connected to the conductive layer 5. The formation of the resistance layer 8 makes it unnecessary to use separate resistance components (electronic components), whereby the number of components can be reduced. As described later, the second surface 2b of the substrate 2 is bonded to the inner surface of the metal case 63 by an adhesive layer. Since the resistance layer 8 is formed on the second surface 2b, heat that is generated by the resistance layer 8 can be dissipated to the outside through the metal case 63, whereby the heat dissipation performance can be increased.

A conductive layer 9 (fourth conductive layer) is formed over a portion of the first surface 2a around the through-hole 3 and in the through-hole 3. Part of the conductive layer 4 and part of the conductive layer 5 are covered with the conductive layer 9.

The conductive layer 9 which is laid on the conductive layer 4 is also formed on a front opening edge 3a of the through-hole 3.

Since the front opening edge 3a of the through-hole 3 is sharp-angled, the conductive layers formed on the front opening edge 3a tend to be thin, possibly resulting in decrease in current capacity and increase in impedance. However, since the conductive layer 4 and the conductive layer 9 are laid on the front opening edge 3a, the total thickness of the conductive layers is so great as to secure a sufficient current capacity.

A conductive layer 10 (third conductive layer) is formed over a portion of the second surface 2b around the through-hole 3 and in the through-hole 3. Part of the conductive layer 5 is covered with the conductive layer 10. The conductive layer 10 is composed of a multilayer portion 10a which is formed on the second surface 2b and a closing portion 10b which fills at least part of the through-hole 3.

The conductive layer 10 which is laid on the conductive layer 5 is also formed on a rear opening edge 3b of the through-hole 3.

Since the rear opening edge 3b of the through-hole 3 is sharp-angled, the conductive layers formed on the rear opening edge 3b tend to be thin, possibly resulting in decrease in current capacity and increase in impedance. However, since the conductive layer 5 and the conductive layer 10 are laid on the rear opening edge 3b, the total thickness of the conductive layers is so great as to secure a sufficient current capacity.

A protective glass layer 11 (second protective glass layer) is formed over portions of the first surface 2a of the substrate 2 excluding the portions over which the joining portions 7 by which the electronic components 6 are joined to conductive layer 4 are formed. Part of the conductive layer 4 and part of the conductive layer 9 are covered with and protected by the protective glass layer 11. Part of the protective glass layer 11 goes into the through-hole 3, and part of the conductive layer 9 and the closing portion 10b of the conductive layer 10 are covered with this portion of the protective glass layer 11.

A protective glass layer 12 (first protective glass layer) is formed over the second surface 2b of the substrate 2. The conductive layer 5, the resistance layer 8, and the conductive layer 10 are covered with and protected by the protective glass layer 12.

The thickness of each of the conductive layer 4, the conductive layer 5, the conductive layer 9, the multilayer portion 10a of the conductive layer 10, the protective glass layer 11, and the protective glass layer 12 is about 10 µm, for example.

An insulating layer 13 is formed on the protective glass layer 12 at a thickness of about 60 µm, for example.

An insulative adhesive layer 14 is laid on the insulating layer 13, and the circuit board 1 is bonded and fixed to the inner surface of the metal case 63 by the adhesive layer 14. The thickness of the adhesive layer 14 is about 100 to 150 µm, for example.

In the circuit board 1, since the closing portion 10b of the conductive layer 10 is filled in the through-hole 3, the rear surface of the conductive layer 10 is formed with a shallow recess 10c. However, since the protective glass layer 12 and the insulating layer 13 are laid in this order on the conductive layer 10, this portion is smoothed out by the protective glass layer 12 and the insulating layer 13, as a result of which each of the protective glass layer 12 and the insulating layer 13 has a (generally) flat surface.

A manufacturing method of the circuit board 1 will be described below with reference to Figs. 3-9.

In the manufacturing method of the circuit board 1 described below, the substrate 2 is oriented so that the first surface 2a is located on the upper side when the conductive layers, the protective glass layer, and the other layers are formed on the first surface 2a of the substrate 2. The substrate 2 is oriented so that the second surface 2b is located on the upper side when the conductive layers, the protective glass layer, and the other layers are formed on the second surface 2b of the substrate 2. Therefore, when the conductive layers, the protective glass layer, and the other layers are formed in the through-hole 3, each layer may flow in such a direction as to go into the through-hole 3 due to gravity depending on the viscosity of its material.

First, as shown in Fig. 3, a through-hole 3 is formed through a substrate 2 and a conductive layer 4 is formed on the first surface 2a so as to reach the through-hole 3. The conductive layer 4 is sucked toward the second surface 2b in the through-hole 3, and thereby comes to cover about 2/3, for example, of the depth of the through-hole 3 on the side of the front opening edge 3a.

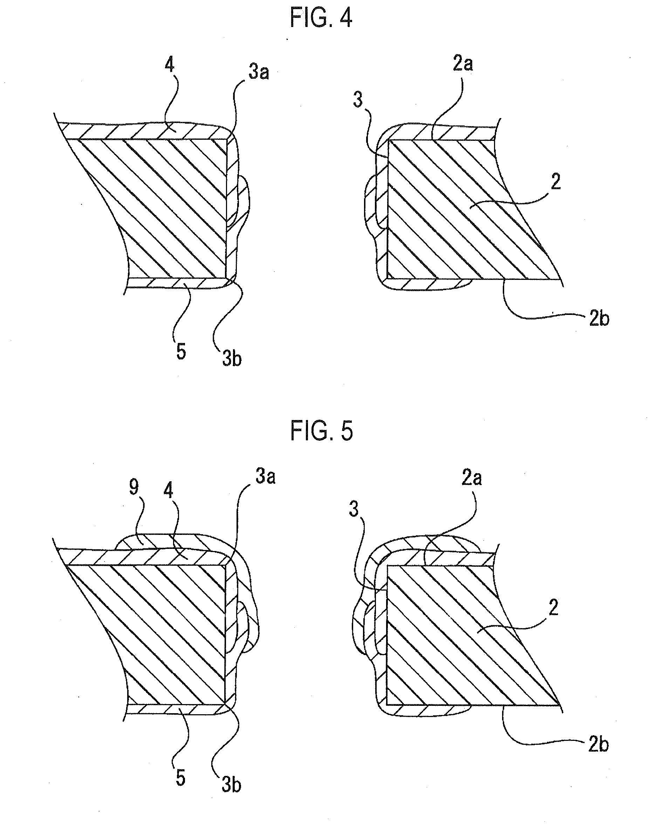

Then, as shown in Fig. 4, a conductive layer 5 is formed on the second surface 2b of the substrate 2 so as to reach the through-hole 3. The conductive layer 5 is sucked toward the first surface 2a in the through-hole 3, and thereby comes to cover about 2/3, for example, of the depth of the through-hole 3 on the side of the rear opening edge 3b, whereby the portion, formed in the through-hole 3, of the conductive layer 4 and the portion, formed in the through-hole 3, of the conductive layer 5 are electrically connected to each other.

Then, as shown in Fig. 5, a conductive layer 9 is formed over a portion of the first surface 2a around the through-hole 3 and in the through-hole 3. The conductive layer 9 is sucked toward the second surface 2b in the through-hole 3, and thereby comes to cover about 2/3, for example, of the depth of the through-hole 3 on the side of the front opening edge 3a. Part of the conductive layer 4 and part of the conductive layer 5 are covered with the conductive layer 9.

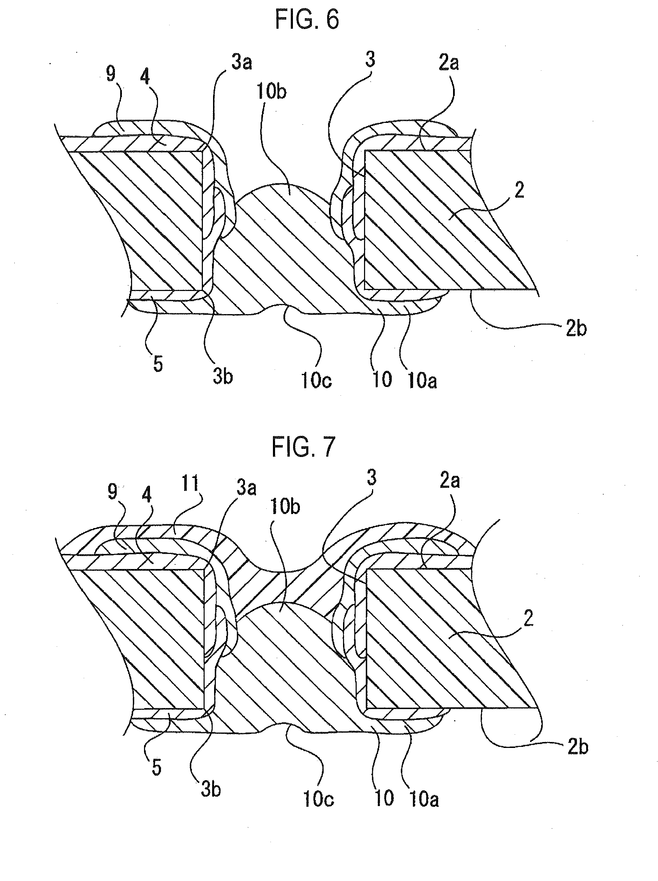

Then, as show in Fig. 6, a conductive layer 10 is formed over a portion of the second surface 2b around the through-hole 3 and in the through-hole 3. The conductive layer 10 is not sucked toward the first surface 2a, and part of the conductive layer 5 and part of the conductive layer 9 are covered with the conductive layer 10. The conductive layer 10 is composed of a multilayer portion 10a which is formed over the second surface 2b and a closing portion 10b which fills at least part of the through-hole 3, for example, the portion of the through-hole 3 other than its front end portion.

As described above, part of the conductive layer 10 flows into the through-hole 3 due to gravity until the tip of the closing portion 10b reaches, for example, a position that is in the vicinity of the first surface 2a.

Then, as shown in Fig. 7, a protective glass layer 11 is formed over the first surface 2a of the substrate 2. The protective glass layer 11 is formed over portions of the first surface 2a excluding portions to which electronic components 6 are to be joined. Part of the conductive layer 4 and part of the conductive layer 9 are covered with and protected by the protective glass layer 11. Part of the protective glass layer 11 goes into the through-hole 3, and part of the conductive layer 9 and the closing portion 10b of the conductive layer 10 are covered with this portion of the protective glass layer 11.

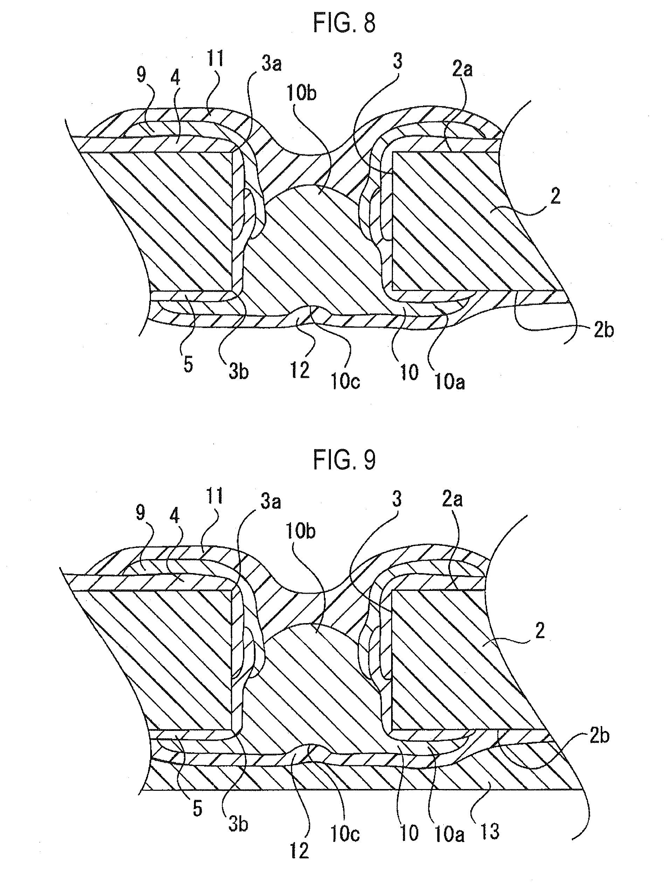

Then, as shown in Fig. 8, a protective glass layer 12 is formed over the second surface 2b of the substrate 2. The conductive layer 5, the resistance layer 8, and the conductive layer 10 are covered with and protected by the protective glass layer 12. The rear surface of the conductive layer 10 is formed with a shallow recess 10c. However, since the protective glass layer 12 is laid on the conductive layer 10, this portion is smoothed out by the protective glass layer 12, as a result of which the protective glass layer 12 is formed so as to have a generally flat surface.

Then, as shown in Fig. 9, an insulating layer 13 is laid on the protective glass layer 12. The insulating layer 13 enhances the smoothing effect and hence is formed so as to have a flat surface.

Then, electronic components 6 are joined to the conductive layer 4 by joining portions 7 such as solder or joining layers.

Finally, an insulative adhesive layer 14 is laid on the insulating layer 13 and the circuit board 1 is bonded and fixed to the inner surface of a metal case 63 by the adhesive layer 14.

As described above, in the circuit board 1, the conductive layer 5 and the conductive layer 10 are laid in this order on the rear opening edge 3b of the through-hole 3. The total thickness of the conductive layers 5 and 10 is so large as to secure a sufficient current capacity, whereby good electrical continuity can be secured between the conductive layer 4 and the conductive layer 5.

The conductive layer 10 is formed over the second surface 2b and in the through-hole 3 and at least part of the through-hole 3 is filled with the closing portion 10b. Therefore, each of the insulating layer 13 and the bonding layer 14 has a (generally) flat surface, that is, has no large thickness variation, whereby high insulation of the circuit board 1 from the metal case 63 can be attained.

Furthermore, since the insulating layer 13 is formed between the protective glass layer 12 and the bonding layer 14, the insulation of the circuit board 1 from the metal case 63 can be increased further.

Still further, since the lighting device 62 incorporates the electric device 64 and the circuit board 1 is provided in the lamp chamber 54 of the vehicular lamp 50, it is not necessary to provide a waterproof portion dedicated to the circuit board 1. Thus, the circuit board 1 can be simplified in structure and reduced in manufacturing cost.

The shapes and structures of the individual members that have been described in the best mode for carrying out the invention are just examples of implementations of the invention, and the technical scope of the invention should not be construed restrictively by them.

## Claims

1. A circuit board comprising:
an insulative substrate (2) having a first surface (2a) on which an electronic component (6) is mounted, a second surface (2b) which is opposite to the first surface (2a), and a through-hole (3) which is open in the first surface (2a) and the second surface (2b);
a first conductive layer (4) which is formed on the first surface (2a) so as to reach the through-hole (3) and to which the electronic component (6) is electrically connected;
a second conductive layer (5) which is formed on the second surface (2b) so as to reach the through-hole (3) and which is electrically connected to the first conductive layer (4) through the through-hole (3);
a resistance layer (8) which is formed on the second surface (2b) and electrically connected to the second conductive layer (5);
a third conductive layer (10) which is formed over the second surface (2b) so as to reach the through-hole (3), covers at least part of the second conductive layer (5), and fills at least part of the through-hole (3);
a first protective glass layer (12) which covers the second conductive layer (5), the third conductive layer (10), and the resistance layer (8); and
an adhesive layer (14) which is formed on the first protective glass layer (12).

2. The circuit board according to claim 1, further comprising:
an insulating layer (13) formed between the first protective glass layer (12) and the adhesive layer (14).

3. The circuit board according to claim 1 or 2, further comprising:
a fourth conductive layer (9) which is formed over the first surface (2a) so as to reach the through-hole (3) and covers at least part of the first conductive layer (4); and
a second protective glass layer (11) which is formed over the first surface (2a) so as to reach the through-hole (3) and covers at least part of the first conductive layer (4) and at least part of the third conductive layer (10).

4. An electric device comprising:
a metal case (63);
a circuit board (1) according to claim 1 attached to the metal case (63),
wherein the adhesive layer (14) is formed between the first protective glass layer (12) and a surface of the metal case (63), and
wherein the electric device (64) is used as a lighting device (62) for lighting a light source provided in a vehicular lamp (50), and the circuit board (1) is provided in a lamp chamber (54) of the vehicular lamp (50).

5. A method of manufacturing a circuit board, comprising:
forming a through-hole (3) through an insulative substrate (2) having a first surface (2a) on which an electronic component (6) is to be mounted and a second surface (2b) which is opposite to the first surface (2a) in such a manner that the through-hole (3) is open in the first surface (2a) and the second surface (2b);
forming a first conductive layer (4) on the first surface (2a) so as to reach the through-hole (3), the first conductive layer (4) being to be electrically connected to the electronic component (6);
forming a second conductive layer (5) on the second surface (2b) so as to reach the through-hole (3) and to be electrically connected to the first conductive layer (4) through the through-hole (3);
forming a third conductive layer (10) over the second surface (2b) so as to reach the through-hole (3), to cover at least part of the second conductive layer (5), and to fill at least part of the through-hole (3);
forming a protective glass layer (12) over the second surface (2b) so that it covers the second conductive layer (5) and the third conductive layer (10); and
forming an adhesive layer (14) on the protective glass layer (12).

6. The method of manufacturing a circuit board according to claim 5, further comprising:
forming a resistance layer (8) formed on the second surface (2b),
wherein the adhesive layer (14) is formed between the protective glass layer (12) and an inner surface of a metal case (63) so that the circuit board is covered with the metal case (63).
